# FASCICULE DE BREVET EUROPEEN

(11) **EP 0 588 700 B1**
(45) Date de publication et mention de la délivrance du brevet: **27.12.2000**
(21) Numéro de dépôt: 93402217.9
(22) Date de dépôt: 13.09.1993
(51) Int. Cl.: G11C 7/00

(54) **Mémoire de programme à semi-conducteur protégée en lecture**
Lesegeschützter Programmspeicher
Read protected semi-conductor program memory

(30) Priorité: 16.09.1992 FR 9211031
(43) Date de publication de la demande: 23.03.1994
(73) Titulaire: MHS, 44087 Nantes Cédex 03 (FR)
(72) Inventeur: Bordiec, René, F-44300 Nantes (FR)
(74) Mandataire: Fréchède, Michel

(56) Documents cités:
- EP-A- 0 040 045
- EP-A- 0 131 151
- EP-A- 0 348 895
- US-A- 4 318 014
- US-A- 5 131 091
- IBM TECHNICAL DISCLOSURE BULLETIN. vol. 19, no. 11 , Avril 1977 , NEW YORK US pages 4197 - 4198 JACOBSON 'WORD-LINE FAILURE DETECTION CIRCUIT'
- PATENT ABSTRACTS OF JAPAN vol. 9, no. 50 (P-339)5 Mars 1985 & JP-A-59 188 897 (HITACHI)

## Description

La présente invention est relative à une mémoire de programme à semi-conducteur protégée en lecture.

Les mémoires de programme à semi-conducteur, de type mémoire morte, sont actuellement largement utilisées, en raison de leur fiabilité et de leur niveau d'intégration des circuits correspondants.

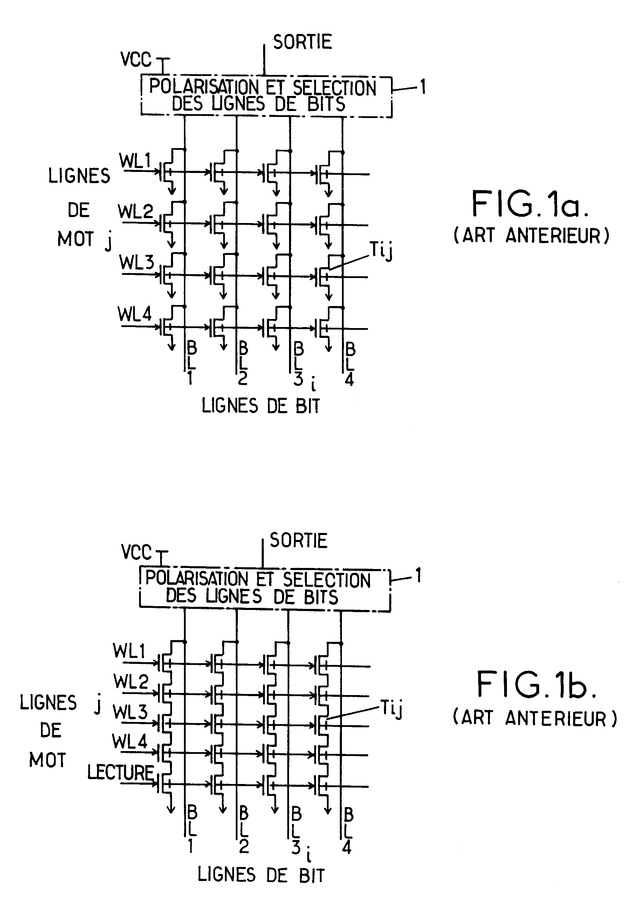

Sur la figure 1a, on a représenté un dispositif de mémoire à semi-conducteur de type mémoire morte classique, constitué par des transistors de type N par exemple, ces transistors, notés T_{ij,} étant disposés et adressés sous forme matricielle en lignes et colonnes. Le nombre de points mémoires, au niveau desquels une variable logique est susceptible d'être mémorisée, est le produit m x n du nombre de lignes m par le nombre de colonnes n.

Les grilles des transistors d'une même ligne sont électriquement reliées à une ligne de mot, WL₁ à WL₄, et les transistors d'une même colonne sont reliés à une ligne de bit, BL₁ à BL₄, polarisée à l'état haut, niveau logique 1.

La programmation des points mémoire consiste alors à isoler ces transistors de la ligne de bit suivant le niveau logique désiré, 1 ou 0. Cette opération est réalisée à un niveau de fabrication spécifique, niveau métal généralement.

Ainsi, un transistor N situé sur une ligne de mot sélectionnée, par un adressage en lecture, provoque la décharge de la ligne de bit à l'état bas, niveau logique 0, si le drain de ce transistor est connecté à cette ligne de bit, la source de celui-ci étant connectée à la tension d'alimentation Vss.

Sur la figure 1b, on a représenté un dispositif mémoire dans lequel les transistors N d'une même colonne sont interconnectés en série, de telle manière que seul l'un d'eux soit relié à une ligne de bit. Tous les transistors N d'une même ligne ont leur grille connectée à une ligne de mot et toutes les lignes de mot sont polarisées à l'état haut, valeur logique 1, sauf celle qui est sélectionnée, par un adressage en lecture. Un transistor L dont la grille est connectée à la ligne précité passe à l'état bloqué, ce qui interdit la décharge de la ligne de bit, et détermine donc un niveau de programmation 1. La programmation d'un niveau de programmation 0 est obtenue en court-circuitant drain et source au niveau métal, ou en déplétant ce transistor, de façon à permettre la décharge de la ligne de bit.

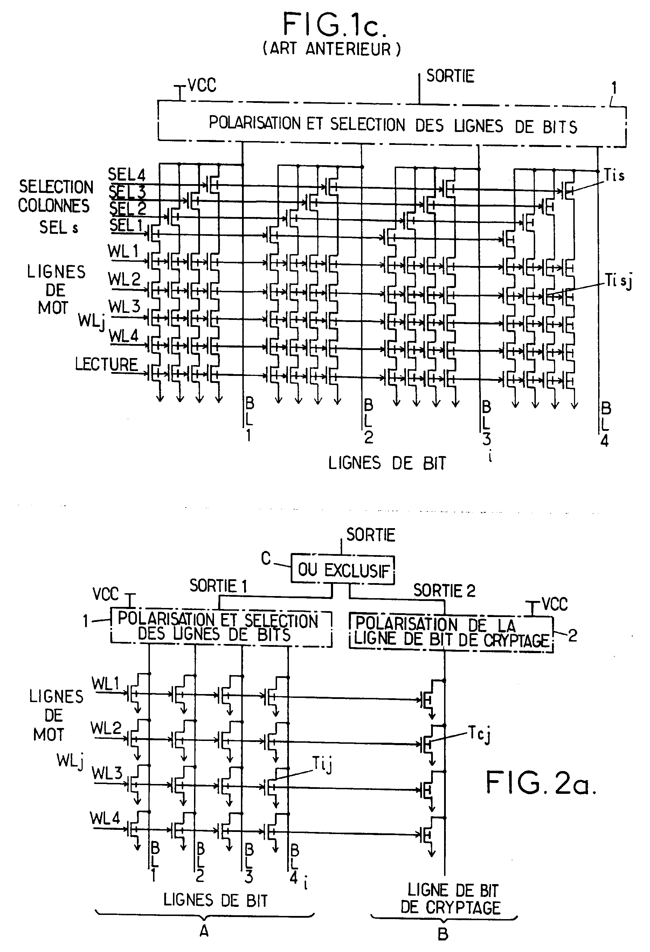

La figure 1c, enfin, représente un dispositif mémoire dérivé du dispositif représenté en figure 1b, et dans lequel plusieurs colonnes sont reliées à une même ligne de bit par des transistors N d'accès ou de sélection, notés Tᵢₛ, commandés par des lignes de sélection SEL₁ à SEL₄, de façon qu'une seule de ces colonnes soit connectée à la ligne de bit précitée. Tous les transistors d'accès d'une même ligne ont leur grille connectée à la même ligne de sélection, les transistors de mémorisation étant notés Tᵢₛⱼ.

Ce type de mémoire morte donne tout à fait satisfaction, du point de vue de son fonctionnement. Toutefois, un accés physique séquentiel aux lignes de bit et lignes de mot permet directement la lecture du programme ou des données mémorisées, en l'absence de toute possibilité de parade à des tentatives intempestives de ce type, les niveaux de protection logicielle ou matérielle susceptibles d'être envisagés ne pouvant en aucun cas être efficaces dans le cas d'un accès direct.

En outre, le document EP-A-0 040 045 décrit un dispositif permettant d'assurer le codage de données au niveau des cellules mémoires, d'une mémoire ROM, dans le but de réduire sur une ligne de mots de cette mémoire le nombre de transistors connectés en parallèle sur la sortie du décodeur d'adresse de ligne afin de diminuer le ralentissement d'accès en lecture à cette mémoire. Les données codées correspondantes sont restituées en clair après décodage et donc en l'absence de tout chiffrement ou cryptage.

Le document US-A-5 131 091 décrit un système de protection d'un programme mémorisé dans une mémoire vive, de type RAM, au moyen de données de protection écrite dans une mémoire accessible en lecture de type ROM. De manière semblable, le document Patent Abstracts of Japan, vol.9, n° 50 P-339 (JP-A-59 188897) décrit un système de protection de données de programme mémorisé dans une mémoire vive RAM, au moyen de données de protection écrites dans une première mémoire ROM. Toutefois, l'accès aux données de protection ne peut être effectué que par l'intermédiaire d'une deuxième mémoire ROM.
Ces documents ne décrivent aucunement la structure des mémoires ROM et RAM utilisées dans ce but.

La présente invention a pour objet de remédier à l'inconvénient précité, afin de supprimer tout risque de lecture par accès direct externe, aux programmes mémoire et aux données mémorisées.

Un autre objet de la présente invention est également la mise en oeuvre d'un système de protection en lecture externe d'une mémoire de programme à semi-conducteur, de type mémoire morte, totalement indiscernable par observation visuelle ou optique des circuits de mémorisation proprement dits.

Un autre objet de la présente invention est enfin la mise en oeuvre d'un système de protection en lecture externe d'une mémoire de programme à semi-conducteur, de type mémoire morte, par cryptage, par lequel tout accès externe pour une lecture fructueuse non autorisée nécessite à la fois la connaissance du contenu des données de cryptage et de l'arrangement matriciel des cellules constituant la mémoire de programme, c'est-à-dire des données ou du programme exécutable mémorisés.

La mémoire de programme à semi-conducteur protégée en lecture de type mémoire morte, objet de la présente invention, est remarquable en ce qu'elle comporte une première zone mémoire de programme destinée à stocker les données de programme, et une deuxième zone mémoire de cryptage, destinée à stocker des données de cryptage. Un opérateur logique interconnecté à la zone mémoire de programme et à la zone mémoire de cryptage permet, sur lecture simultanée des zones mémoire de programme respectivement de cryptage, d'obtenir des données de programme cryptées.

L'invention trouve application à la protection des mémoires mortes à semi-conducteur de type ROM ou EPROM, en particulier pour la réalisation de micro-contrôleurs ou de micro-calculateurs.

L'invention sera mieux comprise à la lecture de la description et à l'observation des dessins ci-après dans lesquels, outre les figures 1a à 1c relatives à l'art antérieur,
- la figure 2a représente une vue générale d'une mémoire de programme, à semi-conducteur, protégée en lecture conformément à l'objet de la présente invention,
- les figures 2b à 2d représentent différents exemples de réalisation de systèmes de polarisation des lignes de bit de la mémoire de programme selon l'invention telle que représentée en figure 2a,
- la figure 3 représente une première variante de réalisation de l'agencement de la mémoire de programme, à semiconducteur protégée en lecture, telle que représentée en figure 2a,
- la figure 4 représente une deuxième variante de réalisation de l'agencement de la mémoire de programme à semiconducteur protégée en lecture telle que représentée en figure 2a,
- la figure 5 représente un schéma d'implantation sous forme de circuit intégré d'une mémoire de programme à semi-conducteur protégée en lecture, selon l'invention, pour une capacité mémoire de n x m mots de k bits,
- la figure 6 représente une variante de réalisation des figures 2a, 3 et 4, dans une application plus particulièrement destinée à un micro-contrôleur ou à un micro-calculateur.

Une description plus détaillée d'une mémoire de programme à semi-conducteur, de type mémoire morte, protégée en lecture, conforme à l'objet de la présente invention sera maintenant donnée en liaison avec les figures 2a et suivantes.

Sur la figure 2a, on constate que la mémoire de programme objet de la présente invention comporte une première zone mémoire de programme, notée A, destinée à stocker les données de programme, et une deuxième zone de mémoire de cryptage, notée B, destinée à stocker les données de cryptage. On comprend bien sûr que les zones A et B comportent effectivement des transistors implantés selon une topographie matricielle, ces transistors étant respectivement reliés à un circuit 1 de polarisation et de sélection des lignes de bit et 2 de polarisation de la ligne de bit de cryptage.

En outre, un opérateur logique, noté C, est interconnecté aux zone mémoire de programme A et zone mémoire de cryptage B et permet, sur lecture simultanée des zones mémoire précitées, d'obtenir des données de programme cryptées en sortie. On comprend bien sûr que l'opérateur logique C est ainsi relié, à deux de ses entrées, à la sortie 1 du circuit de polarisation et sélection des lignes de bit 1, respectivement à la sortie 2 du circuit de polarisation de la ligne de bit de cryptage 2.

Ainsi qu'on l'a représenté en figure 2a, la première zone mémoire de programme A est constituée par un réseau de transistors de type MOS, ces transistors, étant notés Tᵢⱼ, arrangés sous forme matricielle de ligne j et de colonne i. Ainsi, une ligne comporte au moins une ligne de mot, WLⱼ, et une colonne comporte au moins une ligne de bit, BLᵢ. La deuxième zone mémoire de cryptage B comprend une ligne de bit de cryptage. On comprend bien sûr que, sur la figure 2a, la zone mémoire A représentée est relative à un bit, la deuxième zone mémoire B de cryptage comportant alors la ligne de bit de cryptage supplémentaire, ainsi qu'il sera décrit de manière plus détaillée dans la description.

Sur la figure 2a, on remarque que la ligne de bit de cryptage est formée par des transistors, notés Tcⱼ, lesquels sont connectés à la ligne de bit de cryptage, et sont de même type et en nombre identique à ceux connectés aux lignes de bit de la première zone mémoire de programme A.

A l'observation de la figure 2a, on constate également que pour un réseau de transistors MOS dans lesquels les grilles des transistors Tᵢⱼ d'une même ligne sont reliés à une ligne de mot, WLⱼ, et les drains des transistors d'une même colonne sont reliés à une ligne de bit, BLᵢ, la deuxième zone mémoire de cryptage est constituée par les transistors MOS, Tcⱼ, précédemment décrits de même type et en nombre identique dont les drains sont connectés à une ligne de bit de cryptage et les grilles aux lignes de mot WLⱼ.

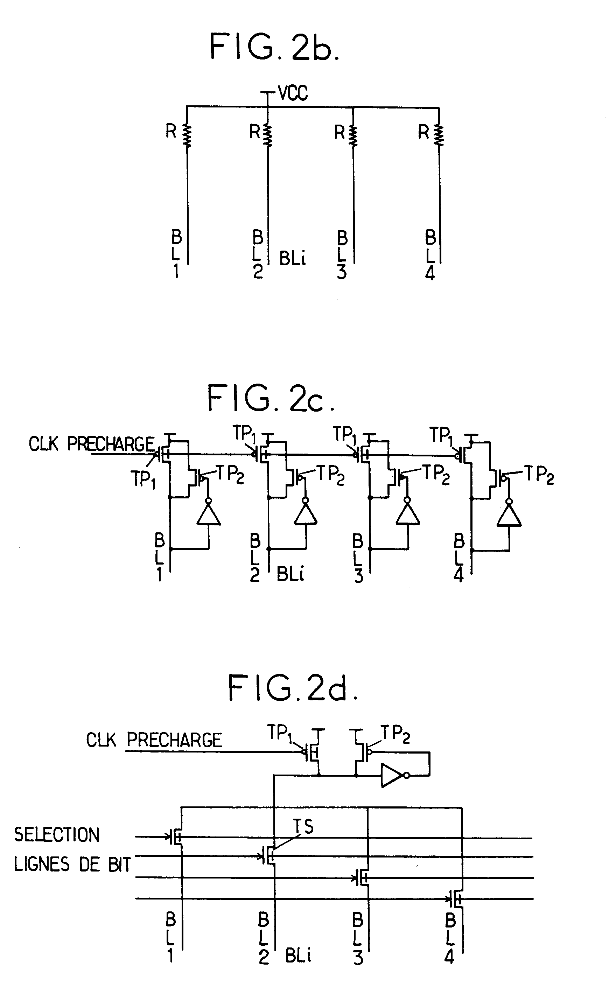

Sur les figures 2b à 2d, on a représenté différentes formes de réalisation des circuits 1 et 2 de polarisation et sélection des lignes de bit.

Ainsi que représenté sur la figure 2b, les lignes de bit sont polarisées par les circuits précités, et sont donc maintenues à l'état haut par des résistances R connectées à la tension d'alimentation, VCC, par exemple.

Ainsi que représenté en figure 2c, elles peuvent être préchargées par des transistors de type P, notés TP₁ et TP₂ sur la figure 2c, sur le niveau logique "0" d'un signal d'horloge CLK, et auto-maintenues à l'état logique "1" par les transistors de type P, ayant une résistance drain-source élevée et notés TP₂ sur la figure 2c, sur le niveau logique opposé du signal d'horloge CLK.

Toutefois, le système de précharge, ainsi que représenté en figure 2d, peut être commun à plusieurs lignes de bit. Dans ce cas, la précharge est sélective, ce qui permet de réduire la consommation dynamique en énergie électrique, une seule ligne de bit étant préchargée au cours d'un cycle de lecture, ainsi que représenté en figure 2d, la sélection des lignes de bit étant alors séquentielle.

La liaison entre le circuit de précharge commun et les lignes de bit est alors effectuée par les transistors de sélection, notés TS sur la figure 2d.

On comprend bien sûr que le circuit 2 de polarisation de la ligne de bit de cryptage peut être réalisé de manière analogue au mode de réalisation représenté en figures 2b à 2d relativement au circuit 1 de polarisation et sélection des lignes de bit.

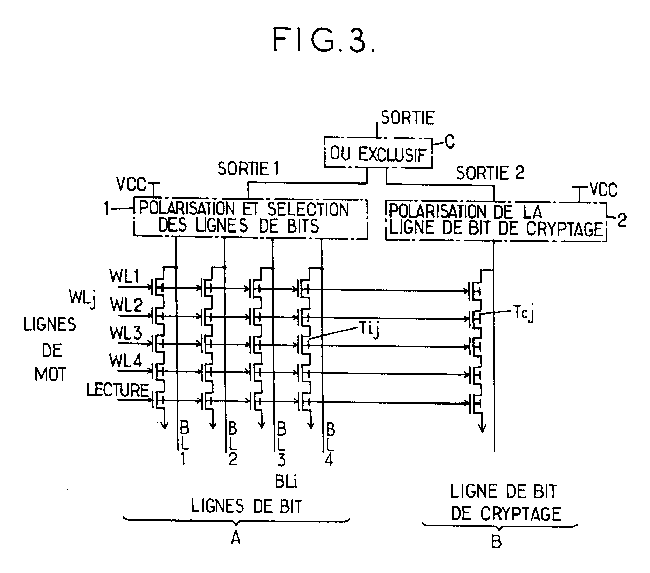

Sur la figure 3, on a représenté une première variante de réalisation de la mémoire de programme à semiconducteur protégée en lecture, conformément à l'objet de la présente invention, tel que représenté en figure 2a.

Dans le cas de la figure 3 précitée, pour un réseau de transistors MOS de la première zone mémoire de programme A dans laquelle les transistors MOS d'une même colonne sont connectés en série, l'un de ces transistors, le transistor de tête, étant relié à une ligne de bit, BLᵢ, et tous les transistors d'une même ligne ayant leur grille connectée à une même ligne de mot, WLⱼ, la deuxième mémoire, ou zone mémoire de cryptage B, est constituée par des transistors série, notés Tcⱼ, de même type et en nombre identique au nombre de transistors constituant les colonnes de transistors associées à chaque ligne de bit, la deuxième mémoire de cryptage étant connectée à une ligne de bit de cryptage, de manière analogue au mode de réalisation de la figure 2a.

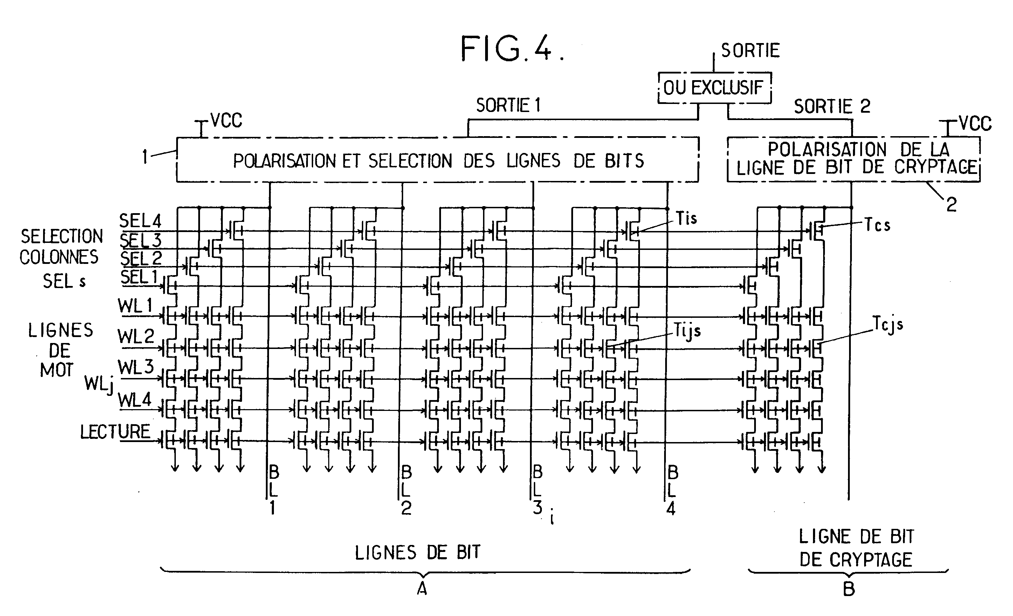

Enfin, dans une deuxième variante de réalisation, telle que représentée en figure 4, pour un réseau de transistors MOS de la première zone mémoire A, dans lequel une pluralité, s, de colonnes de transistors, Tᵢₛⱼ, sont reliés à une même ligne de bit, BLᵢ, par l'intermédiaire de transistors d'accès, Tᵢₛ, agencés en lignes d'accès commandées chacune par une ligne de sélection, SELₛ, une seule colonne, sur commande par un signal de sélection de colonne, étant électriquement connectée à la ligne de bit, alors que les autres colonnes reliées à cette ligne de bit sont électriquement déconnectées de celle-ci, tous les transistors d'accès, Tᵢₛ, d'une même ligne d'accès ont leur grille connectée à une même ligne de sélection, SELₛ, la deuxième zone mémoire B de cryptage est formée d'une même pluralité de colonnes de transistors, Tcⱼₛ, connectées à une ligne de bit de cryptage. On comprend bien sûr que dans le cadre de la figure 4, les zones mémoire A et B sont également relatives aux zones mémoire d'un bit de rang donné, l'accès à une colonne déterminée de rang s étant ainsi commandé séquentiellement par les lignes de sélection de colonne, SELₛ, ce qui permet de multiplier le nombre de bits de même rang ainsi mémorisés, et en définitive le nombre de mots mémorisés, ainsi qu'il sera décrit ultérieurement dans la description, tout en réduisant la consommation d'énergie électrique d'alimentation.

Les circuits de polarisation et de sélection des lignes de bit 1 et de la ligne de bit de cryptage 2 sont identiques à ceux représentés en figure 2a ou 3.

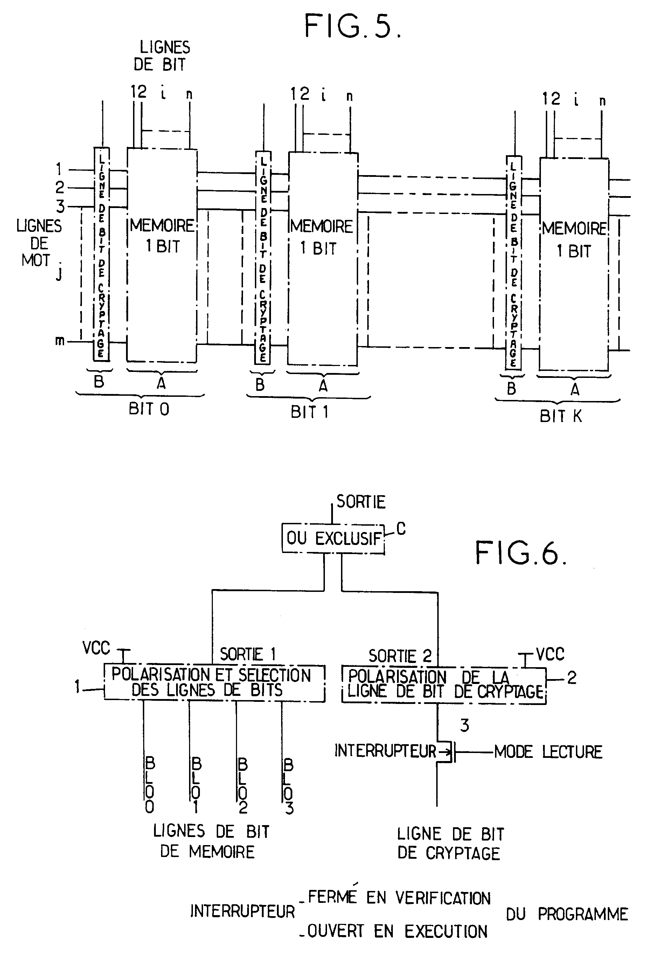

Sur la figure 5, on a représenté un schéma d'implantation en circuit intégré de l'une ou l'autre des variantes de réalisation de la mémoire de programme à semi-conducteur protégé en lecture, objet de la présente invention, tel que représenté en figures 2a, 3 ou 4.

Bien entendu, on comprend que la deuxième zone mémoire B peut être implantée indifféremment à droite ou à gauche de la première zone mémoire de programme A.

Pour des mots codés sur k bits, et ainsi que représenté sur la figure 5 pour chaque bit de rang correspondant, le circuit mémoire de programme protégé conforme à l'objet de la présente invention comprend, pour chaque bit, les zones de mémoire A et B précédemment décrites dans la description. Sur la figure 5, les circuits de polarisation et de sélection des lignes de bit, respectivement lignes de bit de cryptage 1, 2, n'ont pas été représentés, afin de ne pas surcharger le dessin. On comprend ainsi que pour des réseaux matriciels constitutifs des première, A, et deuxième, B, zones mémoires, réseaux matriciels comportant, ainsi que représenté sur la figure 5, m lignes et n colonnes, et pour k couples de zones mémoire A, B, ainsi implantées, on obtient une mémoire de capacité m x n mots de k bits.

On comprend en outre que la ou les lignes de bit de cryptage et les transistors constitutifs d'au moins une colonne correspondante de la ligne de bit de cryptage de la deuxième zone mémoire B de cryptage sont ainsi intégrés au réseau de transistors de lignes de bit de la première zone de mémoire A, chaque transistor d'une ou plusieurs colonnes de la ligne de bit de cryptage ayant sa grille connectée aux grilles des transistors de la première zone mémoire de données appartenant à la même ligne, par l'intermédiaire d'une même ligne de mot.

On comprend également que le fait de constituer la deuxième zone mémoire B de manière identique du point de vue de l'architecture semi-conducteur aux lignes de bit ou à tout le moins aux colonnes associées à la ligne de bit correspondante de la première zone mémoire A, permet bien entendu de rendre la mémoire de cryptage et la mémoire de programme, c'est-à-dire les zones B et A, indiscernables l'une de l'autre par des moyens d'observation optiques.

Ainsi qu'on l'a représenté en outre sur l'ensemble des figures 2a et suivantes, l'opérateur logique C peut être constitué par un opérateur de type OU exclusif.

L'algorithme de pointage dans la mémoire de cryptage peut être déterminé par des combinaisons de bit d'adresse de la mémoire de programme correspondante. Ainsi, l'accès non autorisé et le piratage du code de programme mémorisé dans la zone de mémoire A nécessite de connaître à la fois le contenu de la table de cryptage et l'architecture de la matrice constitutive de la première zone mémoire A.

Dans le but de crypter les données, d'autres opérateurs logiques que le OU exclusif peuvent être utilisés. Toutefois, le OU exclusif offre, du fait de l'unicité de la solution de cryptage procurée, telle que décrite dans le tableau ci-après, le meilleur résultat en raison de la simplicité de la fonction correspondante obtenue par la mise en oeuvre de cet opérateur.

| OU-EXCLUSIF | | |
|---|---|---|
| X | Y | S |
| O | O | O |
| O | 1 | 1 |
| 1 | O | 1 |
| 1 | 1 | O |

| | | |
|---|---|---|
| X étant la donnée de la mémoire principale, | | |
| Y étant la donnée de la mémoire de cryptage, | | |
| S étant la donnée cryptée. | | |

On comprend bien sûr, à l'observation de cette même figure 5, que pour un champ de données codées sur k bits, par mots de k bits, l'opérateur logique comprend k opérateurs OU exclusif élémentaires pour délivrer la donnée cryptée.

La figure 6 représente une application particulière d'un mode de réalisation d'une mémoire conforme à l'objet de la présente invention, plus particulièrement adapté à la mise en oeuvre d'un micro-contrôleur ou d'un micro calculateur.

Ainsi qu'on le remarquera à l'observation de la figure 6, un interrupteur 3 est inséré entre le circuit 2 de polarisation de la ligne de bit de cryptage et la ligne de bit de cryptage proprement dite. Cet interrupteur 3 peut être réalisé par un transistor de type N pouvant assurer la commutation entre un état de vérification et d'exécution du programme.

Lorsque la mémoire de programme contient un code exécutable, comme dans le cas d'un micro-contrôleur par exemple, le mécanisme d'interrupteur précédemment décrit permet d'isoler chaque ligne de bit de cryptage lorsque la lecture de la mémoire s'inscrit dans un cycle d'exécution du programme. En effet, seule la lecture du code par l'extérieur doit être verrouillée, de façon à garantir la protection du logiciel mémorisé dans la mémoire de programme vis-à-vis du piratage.

On a ainsi décrit une mémoire de programme à semiconducteur protégée en lecture de type mémoire morte particulièrement avantageuse, dans la mesure où le piratage des mémoires de programme peut être empêché. Ce résultat est obtenu par le fait que la mémoire de programme et la mémoire de cryptage sont personnalisées simultanément, ce qui assure l'unicité de la protection et garantit la confidentialité des données mémorisées dans la zone mémoire de programme.

## Revendications

1. Mémoire de programme à semi-conducteur protégée en lecture, de type mémoire morte, comportant une première (A) zone mémoire de programme, destinée à stocker les données de programme, ladite première (A) zone mémoire de programme étant constituée par un réseau de transistors MOS (Tᵢⱼ) arrangés sous forme matricielle de lignes (j) et de colonnes (i), une ligne comportant au moins une ligne de mot et une colonne comportant au moins une ligne de bit, et une deuxième (B) zone mémoire de cryptage, destinée à stocker les données de cryptage, caractérisée en ce que ladite deuxième (B) zone mémoire de cryptage comprend une ligne de bit comportant un réseau de transistors MOS (Tcⱼ), arrangés sous forme matricielle de lignes (j), et dont les grilles sont reliées à la ligne de mot correspondante, et en ce que pour un réseau de transistors MOS dans lequels les grilles des transistors (Tᵢⱼ) d'une même ligne sont reliées à une même ligne de mot (WLⱼ), et les drains desdits transistors d'une même colonne sont reliés à une ligne de bit (BL₁), ladite deuxième mémoire de cryptage est constituée par des transistors MOS de même type (Tcⱼ) connectés à une ligne de bit de cryptage et en nombre identique aux transistors MOS de la zone mémoire de données, connectés aux lignes de bit correspondantes, ladite mémoire comportant un opérateur logique (C) interconnecté auxdites zone mémoire de programme et zone mémoire de cryptage et permettant, sur lecture simultanée desdites zones mémoire de programme respectivement de cryptage, d'obtenir des données de programme cryptées.

2. Mémoire selon la revendication 1, caractérisée en ce que pour un réseau de transistors MOS de la première (A) mémoire dans laquelle les transistors MOS d'une même colonne sont connectés en série, l'un de ces transistors étant relié à une ligne de bit (BLᵢ), et tous les transistors d'une même ligne ayant leur grille connectée à une même ligne de mot (WLᵢ) ladite deuxième mémoire de cryptage est constituée par des transisors série (Tcⱼ) de même type et en nombre identique au nombre des transistors constituant lesdites colonnes, ladite deuxième mémoire de cryptage étant connectée à une ligne de bit de cryptage.

3. Mémoire selon la revendication 1, caractérisée en ce que pour un réseau de transistors MOS de la première (A) zone mémoire dans lequel une pluralité (js) de colonnes de transistors (Tᵢₛⱼ) sont reliées à une même ligne de bit (BLᵢ) par l'intermédiaire de transistors d'accès (Tᵢₛ) agencés en lignes d'accès commandées chacune par une ligne de sélection (SELₛ), une seule colonne étant électriquement connectée à ladite ligne de bit alors que les autres colonnes reliées à cette ligne de bit sont électriquement déconnectées de celle-ci, et tous les transistors d'accès (Tᵢₛ) d'une même ligne d'accès ayant leur grille connectée à une même ligne de sélection (SELₛ), ladite deuxième zone mémoire (B) de cryptage est formée d'une même pluralité de colonnes de transistors (Tcⱼₛ) connectées à une ligne de bit de cryptage.

4. Mémoire selon l'une des revendications 1 à 3, caractérisée en ce que chaque ligne de bit de cryptage de la deuxième zone mémoire de cryptage comporte un système de précharge, un système de polarisation de même type que celui des autres lignes de bit de la première zone mémoire de programme.

5. Mémoire selon l'une des revendications 1 à 4, caractérisée en ce que la ou lesdites lignes de bit de cryptage et les transistors constitutifs d'au moins une colonne correspondante de ladite ligne de bit de cryptage de la deuxième zone mémoire de cryptage sont intégrés au réseau de transistors des lignes de bit de la première zone mémoire, chaque transistor d'une ou plusieurs colonnes de ladite ligne de bit de cryptage ayant sa grille connectée aux grilles des transistors de la première zone mémoire de données appartenant à la même ligne, par l'intermédiaire d'une même ligne de mot.

6. Mémoire selon l'une des revendications 1 à 5, caractérisée en ce que, pour un champ de données codé par mots de k bits, chaque bit de rang correspondant comprend une zone mémoire (A) et une zone mémoire (B).

7. Mémoire selon l'une des revendications 1 à 6, caractérisée en ce que ledit opérateur logique (C) est un opérateur de type OU exclusif.

8. Mémoire selon la revendication 7, caractérisée en ce que pour un champ de données codées sur k bits, par mots de k bits, ledit opérateur logique comprend k opérateurs OU exclusifs élémentaires pour délivrer la donnée cryptée.

## Claims

1. A read-protected semiconductor program memory of read-only type, including a first (A) program memory area intended for storing the program data, said first (A) program memory area consisting of a network of MOS transistors (Tᵢⱼ) laid out in matrix form with rows (j) and columns (i), a row including at least one word line and a column including at least one bit line, and a second (B) encryption memory area intended for storing encryption data, characterized in that said second (B) encryption memory area comprises a bit line including a network of MOS transistors (Tcj), laid out in matrix form with rows (j), and whose gates are connected to the corresponding word line, and for a network of MOS transistors in which the gates of the transistors (Tᵢⱼ) of any one row are connected to the same word line (WLⱼ), and the drains of said transistors of any one column are connected to a bit line (BLᵢ), said second encryption memory consists of MOS transistors of like type (Tcⱼ) coupled to an encryption bit line and identical in number to the MOS transistors of the data memory area, coupled to the corresponding bit lines, said memory including a logical operator (C) intercoupled with said program memory area and encryption memory area and making it possible, on simultaneous reading of said program respectively encryption memory areas, to obtain encrypted program data.

2. The memory as claimed in claim 1, characterized by for a network of MOS transistors of the first (A) memory in which the MOS transistors of any one column are coupled in series, one of these transistors being connected to a bit line (BLᵢ), and all the transistors of any one row having their gate coupled to the same word line (WLᵢ), said second encryption memory consists of series transistors (Tcⱼ) of like type and identical in number to the number of transistors constituting said columns, said second encryption memory being coupled to an encryption bit line.

3. The memory as claimed in claim 1, characterized in that for a network of MOS transistors of the first (A) memory area, in which network a plurality (js) of columns of transistors (Tᵢₛⱼ) are connected to the same bit line (BLᵢ) by way of access transistors (Tᵢₛ) configured as access lines each controlled by a selection line (SELₛ), a single column being electrically coupled to said bit line whilst the other columns connected to this bit line are electrically uncoupled from it, and all the access transistors (Tᵢₛ) of any one access line having their gate coupled to the same selection line (SELₛ), said second encryption memory area (B) is formed of one plurality of columns of transistors (Tcⱼₛ) coupled to an encryption bit line.

4. The memory as claimed in one of claims 1 through 3, characterized in that each encryption bit line of the second encryption memory area includes a preloading system and a system for biasing of the same type as that of the other bit lines of the first program memory area.

5. The memory as claimed in one of claims 1 through 4, characterized in that said encryption bit line(s) and the transistors making up at least one corresponding column of said encryption bit line of the second encryption memory area are integrated with the network of transistors of the bit lines of the first memory area, each transistor of one or more columns of said encryption bit line having its gate coupled to the gates of the transistors of the first data memory area belonging to the same row, by way of the single word line.

6. The memory as claimed in one of claims 1 through 5, characterized by, for a data field coded in k-bit words, each bit of corresponding rank comprises a memory area (A) and a memory area (B).

7. The memory as claimed in one of claims 1 through 6, characterized in that said logical operator C is an exclusive OR-type operator.

8. The memory as claimed in claim 7, characterized in that for a field of data coded on k bits, in k-bit words, said logical operator comprises k elementary exclusive OR operators in order to deliver the encrypted datum.

## Patentansprüche

1. Lesegeschützter Halbleiter-Programmspeicher vom Festwertspeichertyp, mit einer ersten Programmspeicherzone (A), die zum Speichern der Programmdaten vorgesehen ist, wobei die erste Programmspeicherzone (A) aus einem Netz von MOS-Transistoren (Tᵢⱼ) besteht, die in Matrixform mit Zeilen (j) und Spalten (i) angeordnet sind, wobei eine Zeile mindestens eine Wortleitung aufweist und eine Spalte mindestens eine Bitleitung aufweist, und einer zweiten Verschlüsselungs-Speicherzone (B), die zum Speichern der Verschlüsselungsdaten vorgesehen ist, dadurch gekennzeichnet, daß die zweite Verschlüsselungs-Speicherzone (B) eine Bitleitung mit einem Netz von MOS-Transistoren (Tcⱼ) aufweist, die in Matrixform mit Zeilen (j) angeordnet sind, und deren Gates mit der entsprechenden Wortleitung verbunden sind, sowie dadurch, daß bei einem Netz von MOS-Transistoren, in dem die Gates der Transistoren (Tᵢⱼ) einer gleichen Zeile mit einer gleichen Wortleitung (WLⱼ) verbunden sind, und die Drains der Transistoren einer gleichen Spalte mit einer Bitleitung (BL₁) verbunden sind, der zweite Verschlüsselungsspeicher aus MOS-Transistoren von einem gleichen Typ (Tcⱼ) besteht, die mit einer Verschlüsselungs-Bitleitung verbunden sind, die gleiche Anzahl wie die MOS-Transistoren der Datenspeicherzone aufweisen, und mit den entsprechenden Bitleitungen verbunden sind, wobei der Speicher einen logischen Operator (C) aufweist, der zwischen die Programmspeicherzone und die Verschlüsselungs-Speicherzone geschaltet ist und es bei gleichzeitigem Lesen der Programm- bzw. Verschlüsselungs-Speicherzonen gestattet, verschlüsselte Programmdaten zu erhalten.

2. Speicher nach Anspruch 1, dadurch gekennzeichnet, daß bei einem Netz von MOS-Transistoren des ersten Speichers (A), in dem die MOS-Transistoren einer gleichen Spalte in Reihe verbunden sind, einer dieser Transistoren mit einer Bitleitung (BLᵢ) verbunden ist, und alle Transistoren einer gleichen Zeile, deren Gate mit einer gleichen Wortleitung (WLᵢ) verbunden ist, der zweite Verschlüsselungsspeicher aus in Reihe geschalteten Transistoren (Tcⱼ) eines gleichen Typs besteht, deren Anzahl gleich derjenigen der Transistoren ist, aus denen die Spalten bestehen, wobei der zweite Verschlüsselungsspeicher mit einer Verschlüsselungs-Bitleitung verbunden ist.

3. Speicher nach Anspruch 1, dadurch gekennzeichnet, daß bei einem Netz von MOS-Transistoren der ersten (A) Speicherzone, in dem eine Mehrzahl (js) von Spalten von Transistoren (Tᵢₛⱼ) mit einer gleichen Bitleitung (BLᵢ) über Zugriffstransistoren (Tᵢₛ) verbunden sind, die in Zugriffsleitungen angeordnet sind, die jeweils über eine Auswahlleitung (SELₛ) gesteuert werden, wobei eine einzige Spalte mit der Bitleitung elektrisch verbunden ist, während die anderen mit dieser Bitleitung verbundenen Spalten mit dieser elektrisch nicht verbunden sind, und die Gates aller Zugriffstransistoren (Tᵢₛ) einer gleichen Zugriffsleitung mit einer gleichen Auswahlleitung (SELₛ) verbunden sind, die zweite Verschlüsselungs-Speicherzone (B) aus einer gleichen Mehrzahl von Spalten von Transistoren (Tcⱼₛ) besteht, die mit einer Verschlüsselungs-Bitleitung verbunden sind.

4. Speicher nach einem der Ansprüche 1 bis 3, dadurch gekennzeichnet, daß jede Verschlüsselungs-Bitleitung der zweiten Verschlüsselungs-Speicherzone ein Vorladesystem aufweist, ein Polarisationssystem vom gleichen Typ wie dasjenige der anderen Bitleitungen der ersten Programmspeicherzone.

5. Speicher nach einem der Ansprüche 1 bis 4, dadurch gekennzeichnet, daß die Verschlüsselungs-Bitleitung(en) und die Transistoren, welche mindestens eine entsprechende Spalte der Verschlüsselungs-Bitleitung der zweiten Verschlüsselungs-Speicherzone bildet/bilden, in das Netz von Transistoren der Bitleitungen der ersten Speicherzone integriert sind, wobei das Gate eines jeden der Transistoren von einer oder mehreren Spalten der Verschlüsselungs-Bitleitung über eine gleiche Wortleitung mit den Gates der Transistoren der zur gleichen Leitung gehörenden ersten Datenspeicherzone verbunden ist.

6. Speicher nach einem der Ansprüche 1 bis 5, dadurch gekennzeichnet, daß bei einem durch Wörter mit k Bits codierten Datenfeld jedes entsprechende Rangbit eine Speicherzone (A) und eine Speicherzone (B) besitzt.

7. Speicher nach einem der Ansprüche 1 bis 5, dadurch gekennzeichnet, daß der logische Operator (C) ein Operator vom ausschließenden ODER-Typ ist.

8. Speicher nach Anspruch 7, dadurch gekennzeichnet, daß bei einem durch Wörter mit k Bits auf k Bits codierten Datenfeld der logische Operator k einzelne ausschließende ODER-Operatoren zum Ausgeben der verschlüsselten Information aufweist.
